# EUROPEAN PATENT APPLICATION

(11) **EP 4 852 641 A1**
(43) Date of publication of application: **09.12.2026**
(21) Application number: 25808033.2
(22) Date of filing: 21.05.2025
(51) Int. Cl.: H05K 9/00, H05K 7/20, C09K 5/14

(54) **ELECTRONIC DEVICE INCLUDING SHIELD CAN**

(30) Priority: 21.05.2024 KR 20240066055; 10.09.2024 KR 20240123353
(71) Applicant: Samsung Electronics Co., Ltd., Suwon-si, Gyeonggi-do 16677 (KR)
(72) Inventor: PARK, Min, Suwon-si, Gyeonggi-do 16677 (KR); YOON, Jeonggen, Suwon-si, Gyeonggi-do 16677 (KR); HWANG, Jieun, Suwon-si, Gyeonggi-do 16677 (KR); SON, Jihyeon, Suwon-si, Gyeonggi-do 16677 (KR); CHANG, Yoonhee, Suwon-si, Gyeonggi-do 16677 (KR); JUNG, Dongkee, Suwon-si, Gyeonggi-do 16677 (KR); JUNG, Jinhwan, Suwon-si, Gyeonggi-do 16677 (KR); JEON, Il, Suwon-si, Gyeonggi-do 16677 (KR); LEE, Sungbok, Suwon-si, Gyeonggi-do 16677 (KR); LEE, Howon, Suwon-si, Gyeonggi-do 16677 (KR); HUH, Jaeyoung, Suwon-si, Gyeonggi-do 16677 (KR)
(74) Representative: Walaski, Jan Filip
(86) International application number: PCT/KR2025/006860
(87) International publication number: WO 2025/244400

(57) **Abstract**

An electronic device according to an embodiment of the disclosure may include a printed circuit board, an electronic component disposed on the printed circuit board, a shield can including a planar portion which includes a seating portion formed to have a groove shape including an injection hole and a side portion which extends from the planar portion, the shield can being coupled to the printed circuit board so as to cover the electronic component, a cover member disposed in the seating portion of the shield can, and a heat transfer material filled inside the shield can, wherein the cover member is configured to be bendable for insertion of an external object for injecting the heat transfer material into the shield can through the injection hole. In addition, various embodiments may be possible.

## Description

### Technical Field

Various embodiments disclosed in the document relate to an electronic device including a shield can.

### Background Art

With the advancement of technology, high-performance electronic components are arranged inside an electronic device. The electronic components may generate heat according to an operation thereof. Heat generated by the electronic components may affect the performance of the electronic components. For example, in case that heat generated by the electronic components is not sufficiently dissipated to the outside of the electronic device, the performance of the electronic component may be degraded. Accordingly, various types of heat dissipation structures are designed for an electronic device in order to release heat generated by electronic components to the outside of an electronic device.

The above-described information may be provided as related art for the purpose of assisting in understanding the disclosure. No assertion or decision is made as to whether any of the above might be applicable as prior art with regard to the disclosure.

### Disclosure of Invention

### Technical Problem

An electronic component such as an application processor (AP), which is a high heat source, may be disposed inside an electronic device. A shield can for covering an electronic component may be disposed on a printed circuit board on which the electronic component is disposed. The shield can may shield electromagnetic waves generated in the electronic component or disperse heat generated by the electronic component to the surrounding area thereof. A liquid heat transfer material for conducting heat generated by the electronic component to the surrounding area thereof may be filled inside the shield can.

Meanwhile, an opening may be formed in a portion of the shield can to allow circuits arranged on a printed circuit board to pass therethrough, the portion being coupled to the printed circuit board. The opening formed in the shield can may be configured to connect the inside and the outside of the shield can. In this case, a heat transfer material filled inside the shield can may be discharged outside the shield can through the opening. Therefore, the heat transfer material may be discharged to an unintended area (e.g., the outside of the shield can) so that the quality of the electronic device may be degraded.

In addition, a nozzle may be inserted into an injection hole formed through the shield can, and a heat transfer material may be sprayed from the nozzle. A cover member for covering the injection hole may be disposed in the shield can to prevent the heat transfer material from flowing back into the injection hole. In case that the cover member is disposed in a shield can, the electronic device may require an inner space including an additional space occupied by the cover member. Therefore, the thickness of the electronic device may increase and/or a space where the electronic component is disposed in the electronic device may become insufficient.

Various embodiments of the present disclosure may provide an electronic device including a shield can capable of helping to prevent or inhibit a phenomenon in which a heat transfer material is discharged to the outside of the shield can through an opening.

Various embodiments may provide an electronic device configured to adjust the composition ratio of a heat transfer material so that a flow rate of the heat transfer material inside the shield can and a degree to which the heat transfer material is sprayed from a nozzle can be controlled.

Various embodiments may provide an electronic device including a shield can capable of preventing an increase in the thickness of the electronic device.

The technical subjects pursued in the disclosure may not be limited to the above-mentioned technical subjects, and other technical subjects which are not mentioned may be clearly understood, through the following descriptions, by those skilled in the art to which the disclosure pertains.

### Solution to Problem

An electronic device according to an embodiment of the disclosure may include a printed circuit board, an electronic component disposed on the printed circuit board, a shield can including a planar portion which includes a seating portion formed to have a groove shape including an injection hole and a side portion which extends from the planar portion, the shield can being coupled to the printed circuit board so as to cover the electronic component, a cover member disposed in the seating portion of the shield can, and a heat transfer material filled inside the shield can, wherein the cover member is configured to be bendable for insertion of an external object for injecting the heat transfer material into the shield can through the injection hole.

An electronic device according to an embodiment of the disclosure may include a printed circuit board, an electronic component disposed on the printed circuit board, a shield can including a planar portion including an injection hole, and a side portion extending from the planar portion and including an opening, the shield can being coupled to the printed circuit board so as to cover the electronic component, a heat transfer material filled inside the shield can through the injection hole, and a first partition wall portion which is positioned between the printed circuit board and the planar portion of the shield can in the shield can and at least a portion of which faces the opening to block the heat transfer material from flowing into the opening.

### Advantageous Effects of Invention

According to an embodiment disclosed in the document, a shield can may include a partition wall portion positioned between the shield can and a printed circuit board in the shield can. At least a portion of the partition wall portion may face an opening of the shield can to block a heat transfer material injected through an injection hole of the shield can from flowing into the opening. Therefore, the phenomenon in which the heat transfer material is discharged to the outside of the shield can through the opening can be prevented.

In addition, by adjusting the composition ratio of a heat transfer material, the speed at which the heat transfer material flows inside the shield can and the degree to which the heat transfer material is discharged from the nozzle can be adjusted.

In addition, the area where a cover member is disposed in a shield can may be formed in a groove or a hole shape, and thus when the cover member is disposed in the shield can, the cover member may be configured so as not to protrude from one surface of the shield can. Therefore, an additional space may not be required as much as the space occupied by the cover member inside an electronic device, and accordingly, an increase in the thickness of the electronic device can be prevented.

In addition, various other effects that can be identified directly or indirectly through the present document may also be provided.

Advantageous effects obtainable from the disclosure may not be limited to the above - mentioned effects, and other effects which are not mentioned may be clearly understood from the following descriptions by those skilled in the art to which the disclosure pertains.

### Brief Description of Drawings

With regard to the description of the drawings, the same or like reference signs may be used to designate the same or like elements.
FIG. 1A is a front perspective view of an electronic device according to an embodiment of the disclosure.
FIG. 1B is a rear perspective view of the electronic device in FIG. 1A according to an embodiment of the disclosure.
FIG. 2 is an exploded perspective view of the electronic device in FIG. 1A according to an embodiment of the disclosure.
FIG. 3A is a front perspective view of a shield can according to an embodiment of the disclosure.
FIG. 3B is a rear perspective view of a shield can according to an embodiment of the disclosure.
FIGS. 4A to 4C are views showing that a phenomenon, in which a heat transfer material injected into a shield can is introduced into an opening of the shield can, is blocked through a first partition wall portion of the shield can according to an embodiment of the disclosure.
FIGS. 5A to 5C are views showing a gap between a first partition wall portion of a shield can and an electronic component of a printed circuit board according to an embodiment of the disclosure.
FIG. 6 is a view showing a second partition wall portion of a shield can, which is disposed to surround a communication module of a printed circuit board according to an embodiment of the disclosure.
FIG. 7A and FIG. 7B are views showing a spaced distance between one surface of a printed circuit board and an injection hole, for preventing a heat transfer material filled in a shield can from flowing back into an injection hole according to an embodiment of the disclosure.
FIGS. 8A and 8B are views showing a seating portion, which has an injection hole formed therethrough and is formed in a groove shape, of a shield can, and a first cover member disposed in the seating portion according to an embodiment of the disclosure.
FIG. 9 is a cross-sectional view taken along line A-A in FIG. 8B.
FIG. 10A is a view showing a second cover member disposed in a hole formed through a seating portion of a shield can according to an embodiment of the disclosure.
FIG. 10B is a view showing a second cover member and a plate coupled to the second cover member according to an embodiment of the disclosure.

### Mode for the Invention

In the following description, embodiments of the disclosure will be described in detail with reference to the accompanying drawings so that those skilled in the art to which the disclosure pertains can readily implement them. However, the disclosure may be embodied in various different forms and is not limited to the embodiments set forth herein. With regard to the description of the drawings, identical or similar reference numerals may be used to designate identical or similar elements. In the drawings and the related description, explanations of well-known functions and configurations may be omitted for the sake of clarity and conciseness.

It should be appreciated that various embodiments of the disclosure and the terms used therein are not intended to limit the technological features set forth herein to particular embodiments and the disclosure includes various changes, equivalents, or alternatives for a corresponding embodiment.

With regard to the description of the drawings, similar reference numerals may be used to designate similar or relevant elements. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

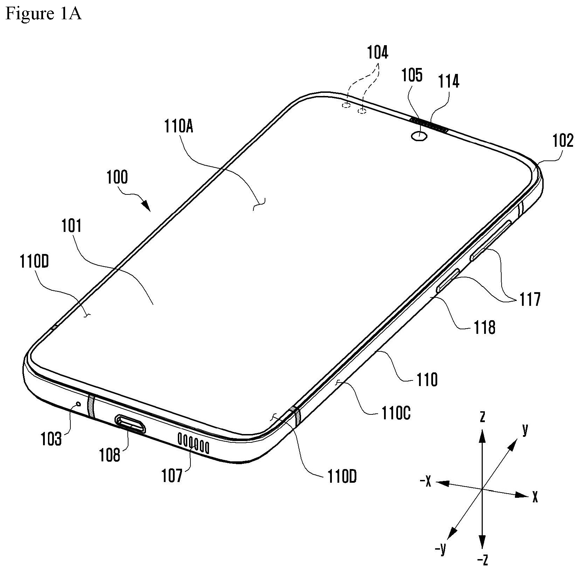

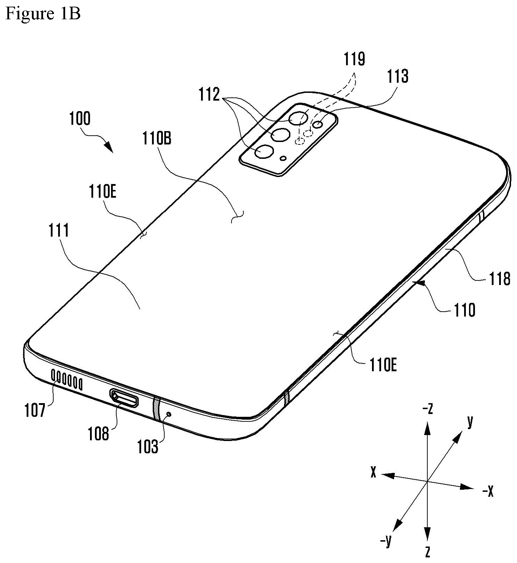

FIG. 1A is a front perspective view of an electronic device according to an embodiment of the disclosure. FIG. 1B is a rear perspective view of the electronic device in FIG. 1A according to an embodiment of the disclosure.

Referring to FIG. 1A and FIG. 1B, an electronic device 100 according to an embodiment may include a housing 110 including a first surface (or a front surface) 110A, a second surface (or a rear surface) 110B, and a side surface 110C surrounding a space between the first surface 110A and the second surface 110B. In an embodiment (not shown), the housing may also be referred to as a structure forming a part of the first surface 110A, the second surface 110B, and the side surface 110C in FIG. 1A. According to an embodiment, the first surface 110A may be formed by a front plate 102 (e.g., a glass plate including various coating layers or a polymer plate) at least a portion of which is substantially transparent. The second surface 110B may be formed by a substantially opaque rear plate 111. For example, the rear plate 111 may be formed by coated or colored glass, ceramic, polymer, metal (e.g., aluminum, stainless steel (STS), or magnesium), or a combination of at least two of the materials. The side surface 110C may be coupled to the front plate 102 and the rear plate 111, and may be formed by a side bezel structure 118 (or a "side member") including metal and/or polymer. In some embodiments, the rear plate 111 and the side bezel structure 118 may be integrally formed, and may include a same material (e.g., a metal material such as aluminum).

In the illustrated embodiment, the front plate 102 may include first areas 110D which are bent and extend seamlessly from the first surface 110A toward the rear plate, the first areas being provided at ends of long edges thereof opposite to each other. In the illustrated embodiment (see FIG. 1B), the rear plate 111 may include second areas 110E which are bent and extend seamlessly from the second surface 110B toward the front plate, the second areas being provided at ends of long edges thereof opposite to each other. In some embodiments, the front plate 102 or the rear plate 111 may include only one of the first areas 110D or the second areas 110E. In some embodiments, the front plate 102 may not include the first areas and the second areas and may include only a flat surface disposed parallel to the second surface 110B. In the embodiments, when viewed from the side surface of the electronic device, the side bezel structure 118 may have a first thickness (or a width) at the side of the side surface not including the first areas 110D or the second areas 110E, and may have a second thickness thinner than the first thickness at the side of the side surface including the first areas 110D or the second areas 110E.

According to an embodiment, the electronic device 100 may include at least one of a display 101, and an input device 103, sound output devices 107 and 114, sensor modules 104 and 119, camera modules 105 and 112, a key input device 117, and indicator (not shown), and a connector hole 108. In some embodiments, at least one (e.g., the key input device 117 or the indicator) of the elements may be omitted from the electronic device 100, and the electronic device 101 may additionally include other elements.

For example, the display 101 may be visually exposed through a substantial portion of the front plate 102. In some embodiments, at least a portion of the display 101 may be exposed through the front plate 102 forming the first surface 110A and the first areas 110D of the side surface 110C. The display 101 may be coupled to or disposed adjacent to a touch detection circuit, a pressure sensor capable of measuring the intensity (pressure) of a touch, and/or a digitizer for detecting a magnetic field type of stylus pen. In some embodiments, at least a portion of the sensor modules 104 and 119 and/or at least a portion of a key input device 117 may be disposed in the first areas 110D and the second areas 110E.

The input device 103 may include a microphone 103. In some embodiments, the input device 103 may include multiple microphones 103 arranged to detect the direction of sound. The sound output devices 107 and 114 may include speakers 107 and 114. The speakers 107 and 114 may include an external speaker 107 and a receiver 114 for phone calls. In some embodiments, the microphone 103, the speakers 107 and 114, and the connector hole 108 may be at least partially arranged in the inner space of the electronic device 100, and may be exposed to an external environment through at least one hole formed through the housing 110. In some embodiments, a hole formed through the housing 110 may be used in common for the microphone 103 and the speakers 107 and 114. In some embodiments, the sound output device 107 or 114 may include a speaker (e.g., a piezo speaker) which is operated in a state where the hole formed through the housing 110 is excluded.

The sensor modules 104 and 119 may generate an electrical signal or a data value corresponding to an internal operation state of the electronic device 100 or an external environmental state. For example, the sensor modules 104 and 119 may include a first sensor module 104 (e.g., a proximity sensor) and/or a second sensor module (not shown) (e.g., a fingerprint sensor) disposed on the first surface 110A of the housing 110, and/or a third sensor module 119 (e.g., an HRM(heart rate monitor) sensor) disposed on the second surface 110B of the housing 110. The fingerprint sensor may be disposed on the first surface 110A (e.g., a home key button) of the housing 110, in a partial area of the second surface 110B, and/or under the display 101. The electronic device 100 may further include a sensor module not illustrated, and for example, include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 105 and 112 may include a first camera module 105 disposed on the first surface 110A of the electronic device 100, and a second camera module 112 and/or a flash 113 disposed on the second surface 110B. The camera modules 105 and 112 each may include one lens or multiple lenses, the processor, an image sensor, and/or an image signal processor. For example, the flash 113 may include a light-emitting diode or a xenon lamp. In some embodiments, two or more lenses (a wide-angle lens, an ultra-wide-angle lens, or telephoto lens) and image sensors may be arranged on one surface of the electronic device 100.

The key input device 117 may be disposed on the side surface 110C of the housing 110. In an embodiment, the electronic device 100 may not include a part or the whole of the key input device 117 mentioned above, and the key input device 117 not included therein may be implemented, on the display 101, as a different type such as a soft key. In an embodiment, the key input device 117 may be implemented using a pressure sensor included in the display 101.

For example, the indicator may be disposed on the first surface 110A of the housing 110. For example, the indicator may provide a state information of the electronic device 100 in the form of light (e.g., a light-emitting element). In an embodiment, for example, the light-emitting element may provide a light source operating in association with an operation of the camera module 105. For example, the indicator may include, an LED, an IR LED, and/or a xenon lamp.

A connector hole 108 may include a first connector hole 108 capable of accommodating a connector (for example, a universal serial bus (USB) connector) for transmitting or receiving power and/or data to or from an external electronic device, and/or a second connector hole (or an earphone jack) (not shown) capable of accommodating a connector for transmitting or receiving an audio signal to or from an external electronic device.

A camera module 105 of the camera modules 105 and 112, a sensor module 104 of the sensor modules 104 and 119, and the indicator may be arranged to be visually exposed through the display 101. For example, the camera module 105, the sensor module 104, or the indicator may be disposed to be in contact with the external environment through an opening formed through the front plate 102 of the display 101 or a transparent area thereof, in the inner space of the electronic device 100. According to an embodiment, an area, in which the display 101 and the camera module 105 face each other, may be a part of an area on which contents are displayed, and be formed as a transmissive area having a predetermined transmissivity. According to an embodiment, the transmissive area may be formed to have a transmissivity in the range of about 5% - about 20%. The transmissive area may include an area overlapping an effective area (e.g., a view angle area) of the camera module 105 through which light for generating an image passes, the light being imaged by an image sensor. For example, the transmissive area of the display 101 may include an area having a pixel density lower than the perimeter area thereof. For example, the transmissive area may replace an opening. For example, the camera module 105 may include an under-display camera (UDC). In an embodiment, the sensor module 104 may also be disposed to perform the function thereof without being visually exposed through the front plate 102 in the inner space of the electronic device. For example, in this case, the area, which faces the sensor module, of the display 101, may not also require an opening formed therethrough.

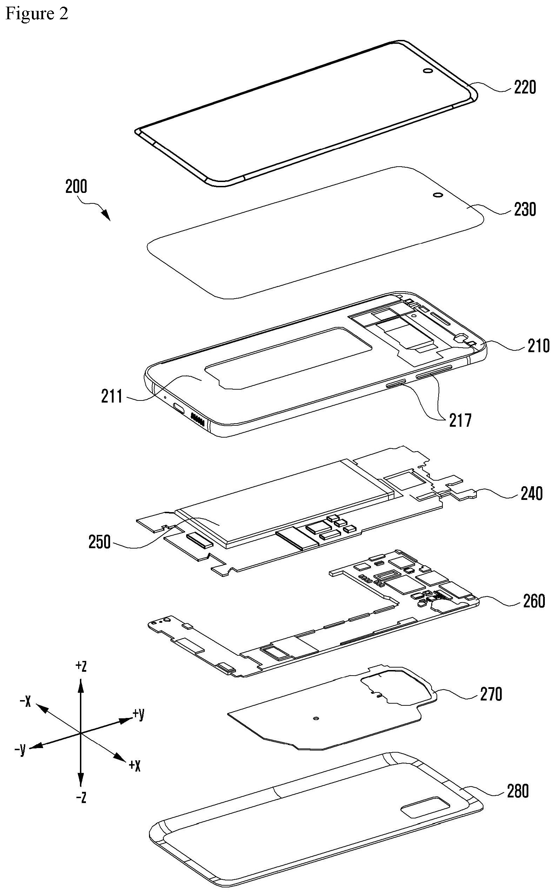

According to an embodiment, the electronic device 100 may have a bar-type exterior or a plate-type exterior, but the disclosure is not limited thereto. For example, the illustrated electronic device 100 may be a part of a foldable electronic device, a slidable electronic device, a stretchable electronic device, and/or a rollable electronic device. A "foldable electronic device", a "slidable electronic device", a "stretchable electronic device", and/or a "rollable electronic device" may mean an electronic device in which a display (e.g., the display 230 in FIG. 2) is bendable and deformable so that at least a portion of the display is folded or wound or rolled, or an area of the display is at least partially expanded and/or is accommodated inside a housing (e.g., the housing 110 in FIG. 1A and FIG. 1B). A foldable electronic device, a slidable electronic device, a stretchable electronic device, and/or a rollable electronic device may be configured such that a display is unfolded or a larger area of a display is exposed to the outside, so as to expand and then use a screen display area thereof, according to user needs.

FIG. 2 is an exploded perspective view of the electronic device in FIG. 1A according to an embodiment of the disclosure.

An electronic device 200 in FIG. 2 may be at least partially similar to the electronic device 100 in FIG. 1A and FIG. 2B, or may include another embodiment of an electronic device.

Referring to FIG. 2, the electronic device 200 (e.g., the electronic device 100 in FIG. 1A or FIG. 2B) may include a side member 210 (e.g., a side bezel structure), a first support member 211 (e.g., a bracket or a support structure), a front plate 220 (e.g., a front cover), a display 230 (e.g., the display 101 in FIG. 1A), a substrate 240 (e.g., a printed circuit board (PCB), a flexible PCB (FPCB), or a rigid-flexible PCB (RFPCB)), a battery 250, a second support member 260 (e.g., a rear case), an antenna 270, and a rear plate 280 (e.g., a rear cover). In some embodiments, at least one (e.g., the first support member 211 or the second support member 260) of elements may be omitted from the electronic device 200, or other elements may be additionally included therein. At least one of elements of the electronic device 200 may be the same as or similar to at least one of the elements of the electronic device 100 in FIG. 1A or FIG. 1B, and overlapping descriptions thereof will be omitted hereinafter.

The first support member 211 may be disposed inside the electronic device 200, and may be connected to the side member 210 or integrally formed with the side member 210. For example, the first support member 211 may be formed of a metal material and/or a non-metal (e.g., polymer) material. The first support member 211 may have one surface to which the display 230 is coupled, and the other surface to which the substrate 240 is coupled. A processor, a memory, and/or an interface may be mounted on the substrate 240. For example, the processor may include one or more of a central processing device, an application processor, a graphic processing device, an image signal processor, a sensor hub processor, and a communication processor.

For example, the memory may include a volatile memory or a non-volatile memory.

For example, the interface may include a high definition multimedia interface (HDMI), a universal serial bus (USB) interface, an SD(secure digital) card interface, and/or an audio interface. For example, the interface may electrically or physically connect the electronic device 300 to an external electronic device, and may include a USB connector, an SD card/MMC(multimedia card) connector, or an audio connector.

The battery 250 may be a device for supplying power to at least one element of the electronic device 200, and for example, may include a non-rechargeable primary cell, a rechargeable secondary cell, or a fuel cell. For example, at least a portion of the battery 250 may be disposed on a plane substantially the same as the substrate 240. The battery 250 may be integrally disposed inside the electronic device 200. In an embodiment, the battery 250 may also be disposed attachably to or detachably from the electronic device 200.

The antenna 270 may be disposed between the rear plate 280 and the battery 250. For example, the antenna 270 may include a near field communication (NFC) antenna, a wireless charging antenna, and/or a magnetic secure transmission (MST) antenna. For example, the antenna 270 may be configured to perform short-range communication with an external device, or may be configured to transmit/receive power required for charging in a wireless. In an embodiment, an antenna structure may be formed by a part of the side bezel structure 210 and/or the first support member 211, or a combination thereof.

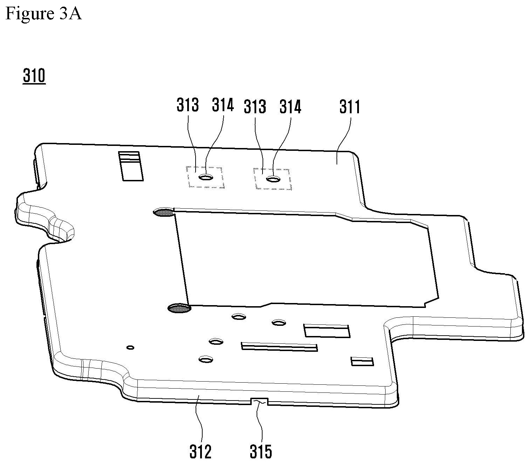

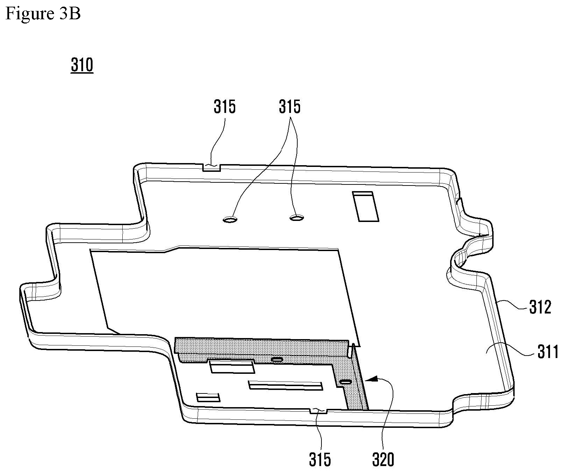

FIG. 3A is a front perspective view of a shield can according to an embodiment of the disclosure. FIG. 3B is a rear perspective view of a shield can according to an embodiment of the disclosure.

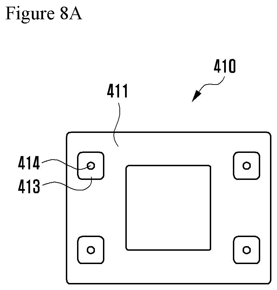

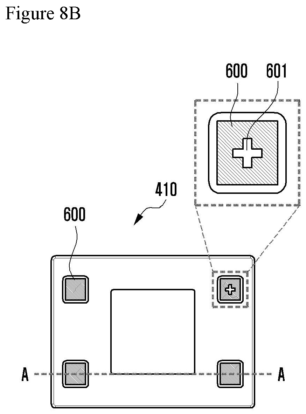

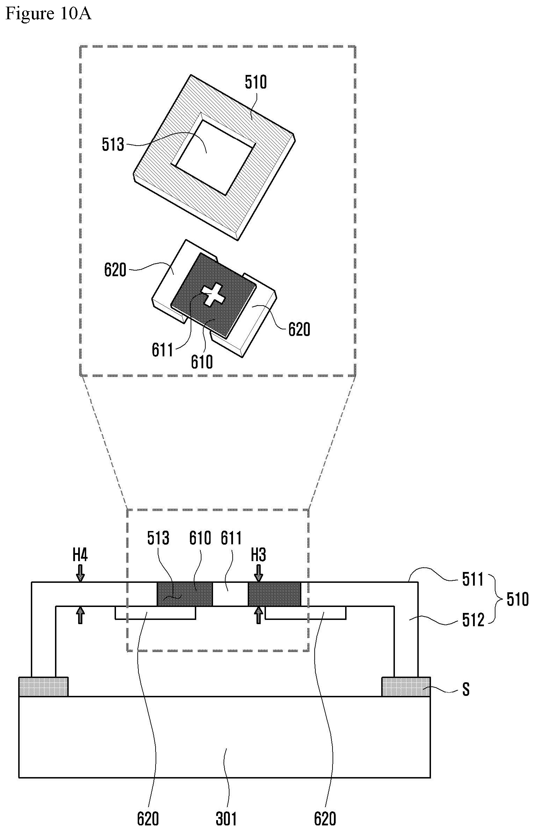

According to an embodiment, an electronic device (e.g., the electronic device 100 in FIG. 1A and FIG. 1B and/or the electronic device 200 in FIG. 2) may include an electronic component 302 having various performances. In an embodiment, the electronic component 302 may be connected to the printed circuit board 301 (e.g., the substrate 340 in FIG. 2) disposed in a housing (e.g., the housing 110 in FIG. 1A) to be electrically operated. The electronic component 302 may generate heat according to an operation thereof. In case that heat generated by the electronic component 302 is not sufficiently dissipated to the outside of the electronic device 100 or 200, the performance of the electronic component 302 may degraded. Accordingly, a heat-dissipating member (e.g., a shield can (e.g., the shield can 310 in FIG. 3A, the shield can 410 in FIGS. 8A and 8B, the shield can 510 in FIG. 10A) and/or a heat transfer material) for dissipating heat generated from the electronic component 302 to the surrounding area thereof may be disposed inside the housing 110.

According to an embodiment, the shield can 310 may be disposed on the printed circuit board 301 to cover at least a portion of the electronic component 302. In an embodiment, referring to FIG. 3A and FIG. 3B, the shield can 310 may include a planar portion 311 (e.g., a front portion) at least a portion of which faces the electronic component 302, and a side portion 312 which extends from the planar portion 311 and is coupled to the printed circuit board 301. In an embodiment, the planar portion 311 may include a surface at least a portion of which is a substantially flat. In an embodiment, the side portion 312 may be bendable in a direction substantially perpendicular to the planar portion 311. In an embodiment, the shield can 310 may be coupled to the printed circuit board 301 as the side portion 312 is soldered to the printed circuit board 301. In addition, the shield can 310 may be coupled to the printed circuit board 301 in various manners such as coupling through a clip or a socket.

In an embodiment, the shield can 310 may include a conductive material in order to shield electromagnetic waves generated in the printed circuit board 301 and the electronic component 302 or disperse heat generated by the electronic component 302 to the surrounding area thereof. For example, the shield can 310 may be formed of a metal material or a material such as graphite. In addition, the shield can 310 may be formed of various materials which shield electromagnetic waves and have thermal conductive properties. In addition, the shield can 310 may be formed of a material having a predetermined level of rigidity so as to protect the electronic component 302 positioned inside the shield can 310 from external impact.

According to an embodiment, a liquid heat transfer material may be injected into the shield can 310. In an embodiment, the heat transfer material may be injected into the shield can 310 so as to disperse heat of the electronic component 302 disposed inside the shield can 310 to the outside of the shield can 310. For example, heat generated by the electronic component 302 may be transferred to the outside of the shield can 310 through the heat transfer material and the shield can 310. Accordingly, the heat generation of the electronic component 302 may be reduced so that a malfunction of the electronic component 302 due to the heat generation thereof is prevented.

According to an embodiment, as illustrated in FIG. 3A, FIG. 3B, and FIG. 8A and FIG. 8B and FIG. 10A described below, an injection hole 314 (e.g., the injection hole 414 in FIG. 8A, and the cut part 611 of the second cover member 610 and/or the seating portion 513 in FIG. 10A), which is a passage into which a liquid heat transfer material is injected, may be formed through the planar portion 311 of the shield can 310. A nozzle for applying the heat transfer material may be inserted into the injection hole 314 of the shield can 310 and may apply the heat transfer material to a space between a printed circuit board 301 and the shield can 310. Therefore, the heat transfer material may be filled in the space between the shield can 310 and the printed circuit board 301.

According to an embodiment, a cover member (e.g., the first cover member 600 in FIGS. 8A and 8B and/or the second cover member 610 in FIG. 10A) for covering an injection hole 314 may be disposed in the shield can 310. In an embodiment, the cover member 600 or 610 may prevent a heat transfer material introduced into the shield can 310 from flowing back into the injection hole 314.

In an embodiment, the cover member 600 or 610 may be disposed in the seating portion 313 of the shield can 310. In an embodiment, the seating portion 313 may be an area where the cover member 600 or 610 is disposed in the shield can 310. In an embodiment, the seating portion 313 may be formed in various shapes.

In an embodiment, referring to FIGS. 8A and 8B described later, a seating portion 413 (e.g., the seating portion 313 in FIG. 3A) may be formed in a groove shape in which one surface of the shield can 410 (e.g., the shield can 310 in FIG. 3A) is concavely formed. In this case, the injection hole 414 (e.g., the injection hole 314 in FIG. 3A) may be formed through the seating portion 413. A cover member (e.g., the first cover member 600) may be disposed in the seating portion 413 having a groove shape, and accordingly, may cover the injection hole 414.

In an embodiment, referring to FIG. 10A described below, a seating portion 513 (e.g., the seating portion 313 in FIG. 3A) may be a hole in which a cover member (e.g., the second cover member 610) is disposed. For example, the seating portion 513 may be a hole having a shape corresponding to the cover member 610 so as to allow the cover member 610 to be disposed therein. If differently defined, the seating portion 513 in FIG. 10A may be an embodiment in which the seating portion 413 is formed in a hole shape instead of a groove shape in FIG. 8A and 8B. In this case, an injection hole (e.g., the injection hole 314 in FIG. 3A) may be a cut part 611 formed by cutting a part of the cover member 610, or an injection hole may be included in the seating portion 513 having a hole shape. In an embodiment, the cut part 611 may be formed to be bendable in a direction into which a nozzle for spraying a heat transfer material is inserted as the nozzle is inserted into the cut part 611, so as to allow the nozzle to be inserted into the shield can 510 (e.g., the shield can 310 in FIG. 3A) and prevent the backflow of the heat transfer material while the nozzle is not inserted therein. The descriptions of the seating portion 313, 413, or 513 of the shield can 310, 410, or 510 and the cover member 600 or 610 according to the shape of the seating portion 313, 413, or 513 will be described with reference to FIGS. 8A to FIG. 10B below.

According to an embodiment, the cover member 600 or 610 may be formed of various materials. For example, the cover member 600 or 610 may be formed of a material having heat resistance and elasticity, such as silicone, urethane, or TPU. Therefore, the cover member 600 or 610 may not be deformed by heat of the heat transfer material. In addition, the cut part 601 or 611 of the cover member 600 or 610 may be restored by elasticity when the nozzle is detached from the cut part.

According to an embodiment, as illustrated in FIG. 3A and FIG. 3B, an opening 315 may be formed in the side portion 312 of the shield can 310. In an embodiment, the opening 315 may be a shape in which one end of the side portion 312 is open. For example, the opening 315 may be a space formed by removing an area of the side portion 312, which faces the printed circuit board 301. In an embodiment, the opening 315 may be configured to allow circuits arranged on the printed circuit board 301 to pass through the inside of the shield can 310 when the shield can 310 is disposed on the printed circuit board 301. In an embodiment, the shield can 310 may be disposed on the printed circuit board 301 to allow an electric circuit disposed on the printed circuit board 301 to pass through the opening 315.

Meanwhile, when a heat transfer material is injected into the inner space (e.g., the space between the shield can 310 and the printed circuit board 301) of the shield can 310 through the injection hole 314 of the shield can 310, the heat transfer material may be discharged from the inside of the shield can 310 to the outside of the shield can 310 through the opening 315 formed in the side portion 312 of the shield can 310. In addition, the opening 315 may be a gap generated between soldering areas as the side portion 312 of the shield can 310 is soldered (e.g., the soldering s in FIG. 10A) to the printed circuit board 301. In this case, when the heat transfer material is injected into the inner space of the shield can 310 through the injection hole 314 of the shield can 310, the heat transfer material may be discharged from the inside of the shield can 310 to the outside of the shield can 310 through the gap between the soldering areas. Therefore, the heat transfer material may be discharged to an unintended area (e.g., the outside of shield can 310) through the opening 315 of shield can 310 and/or the gap between the soldering areas in which the shield can 310 and the printed circuit board 301 are coupled to each other, so that the quality of the electronic device is degraded.

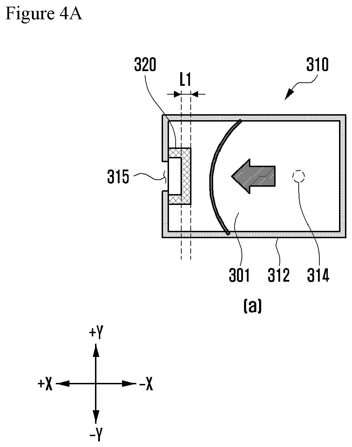

According to an embodiment of the disclosure, as illustrated in FIG. 3B and FIG. 4A to FIG. 5C described below, the shield can 310 may include a first partition wall portion 320. In an embodiment, the first partition wall portion 320 may be disposed between the shield can 310 and the printed circuit board 301 to block a heat transfer material injected between the shield can 310 and the printed circuit board 301 through the injection hole 314 from flowing into the opening 315 of the shield can 310. For example, referring to FIG. 3B and FIGS. 4A to 4C, the first partition wall portion 320 may surround the side portion 312 in which the opening 315 is formed, so as to prevent the heat transfer material from flowing into the opening 315. The first partition wall portion 320 may be formed in a shape, such as a "-" shape, " 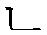 " shape, or "⊏" shape, capable of shielding the opening 315. A detailed description of the first partition wall portion 320 will be described with reference to FIGS. 4A to 5C below.

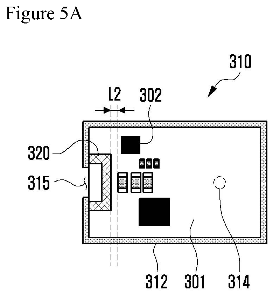

FIGS. 4A to 4C are views showing that a phenomenon, in which a heat transfer material injected into a shield can is introduced into an opening of the shield can, is blocked through a first partition wall portion of the shield can according to an embodiment of the disclosure. FIGS. 5A to 5C are views showing a gap between a first partition wall portion of a shield can and an electronic component of a printed circuit board according to an embodiment of the disclosure.

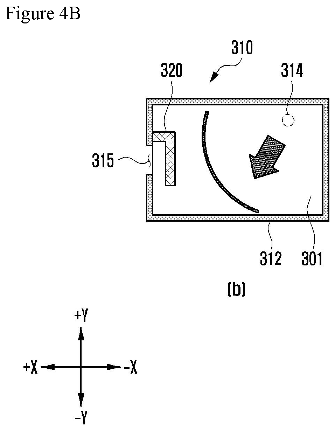

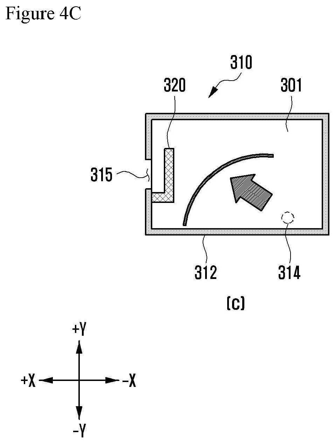

In the following description, FIG. 4A, FIG. 4B, and FIG. 4C may be views showing that the shape of the first partition wall portion 320 may be variously changed based on the positional relationship between the injection hole 314 of the shield can 310 and the opening 315 of the shield can 310.

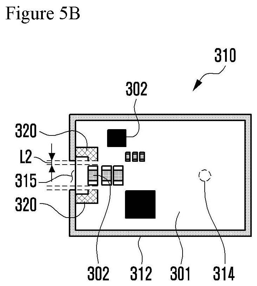

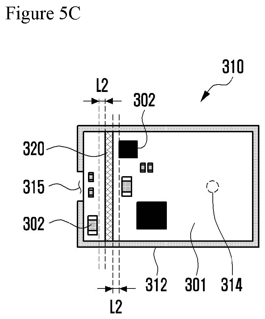

In addition, in the following description, FIG. 5A, FIG. 5B, FIG. 5C may be views showing that the shape of the first partition wall portion 320 may be variously changed according to the arrangement relationship between the electronic component 302 arranged on the printed circuit board 301 and the first partition wall portion 320.

According to an embodiment, as illustrated in FIGS. 4A to 4C, the first partition wall portion 320 may be deformed into various shapes, based on the positional relationship between the injection hole 314 and the opening 315 of the shield can 310.

In an embodiment, referring to FIG. 4A, the first partition wall portion 320 may be disposed in the side portion 312, in which the shield can 310 is formed, to shield the opening 315. For example, the first partition wall portion 320 may be formed in a "⊏" shape to block a heat transfer material filled inside the shield can 310 from flowing into the opening 315. [76] In an embodiment, referring to FIG. 4B, the injection hole 314 of the shield can 310 may be positioned in the -X-axis direction and the +Y-axis direction with respect to the opening 315 of the shield can 310. In this case, when a heat transfer material is introduced through the injection hole 314, the heat transfer material may move in the +X-axis direction and the - Y-axis direction. Accordingly, as illustrated in FIG. 4B, the first partition wall portion 320 may be formed in a " 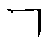 " shape and disposed in the shield can 310, so as to block the heat transfer material from flowing into the opening 315 of the shield can 310.

In an embodiment, referring to FIG. 4C, the injection hole 314 of the shield can 310 may be positioned in the -X-axis direction and the -Y-axis direction with respect to the opening 315 of the shield can 310. In this case, when a heat transfer material is introduced through the injection hole 314, the heat transfer material may move in the +X-axis direction and the +Y-axis direction. Accordingly, as illustrated in FIG. 4C, the first partition wall portion 320 may be formed in a "┘" shape and disposed in the shield can 310, so as to block the heat transfer material from flowing into the opening 315 of the shield can 310.

In an embodiment, referring to FIG. 5A, FIG. 5B, and FIG. 5C, the first partition wall portion 320 may be formed in various shapes according to the position at which the electronic component 302 is disposed on the printed circuit board 301. For example, the first partition wall portion 320 may be formed in a shape which accommodates a part of the electronic component 302 as illustrated in FIG. 5B, and may be formed in a straight line shape and disposed between the electronic components 302 as illustrated in FIG. 5C.

According to an embodiment, as illustrated in FIG. 5A, FIG. 5B, and FIG. 5C, the first partition wall portion 320 may be disposed between the shield can 310 and the printed circuit board 301 so as to have a predetermined interval L2 with respect to the electronic component 302. In an embodiment, as the predetermined interval L2 is secured between the electronic component 302 and the first partition wall portion 320, a tolerance between the electronic component 302 and the first partition wall portion 320 may be allowed.

In an embodiment, as illustrated in FIG. 5B, as the first partition wall portion 320 and the electronic component 302 are arranged at the predetermined interval L2, a part of a heat transfer material may pass through the space between the first partition wall portion 320 and the electronic component 302 and then be introduced into the opening 315 of the shield can 310. Therefore, in order for the heat transfer material to be minimally introduced into the space between the first partition wall portion 320 and the electronic component 302, the interval L2 between the first partition wall portion 320 and the electronic component 302 may be determined in consideration with the viscosity of the heat transfer material and the diffusion speed of the heat transfer material inside the shield can 310.

According to an embodiment, the first partition wall portion 320 may be formed separately from the shield can 310 and then be coupled to the shield can 310. For example, the first partition wall portion 320 may be coupled to the planar portion 311 of the shield can 310 by welding so as to be substantially perpendicular to the planar portion 311 of the shield can 310. In this case, the first partition wall portion 320 may be formed to have a predetermined thickness (e.g., L1 in FIG. 4A) or more so as to be easily joined to the shield can 310.

In an embodiment, the first partition wall portion 320 may be formed integrally with the shield can 310. For example, the first partition wall portion 320 may be formed to extend substantially perpendicularly to the planar portion 311 of the shield can 310 in the process of manufacturing the shield can 310.

In an embodiment, the first partition wall portion 320 may have no gap or have a micro-gap with respect to one surface of the printed circuit board 301 when disposed on the printed circuit board 301 in a state of being coupled to the shield can 310.

According to an embodiment of the disclosure, the first partition wall portion 320 may be disposed between the shield can 310 and the printed circuit board 301 to block a heat transfer material injected between the shield can 310 and the printed circuit board 301 through the injection hole 314 from flowing into the opening 315 of the shield can 310. Therefore, the phenomenon, in which the heat transfer material is discharged to an unintended area (e.g., the outside of shield can 310) through the opening 315 of shield can 310 and/or the gap between the soldering areas in which the shield can 310 and the printed circuit board 301 are coupled to each other, may be prevented.

According to an embodiment, a heat transfer material may be required to have a predetermined level of thermal conductivity so as to conduct heat generated by the electronic components 302 to the surrounding area thereof. In addition, a heat transfer material may be required to have a predetermined level of viscosity so as to be easily filled into the inner space of the shield can 310. In case that a heat transfer material is formed with low viscosity, after the heat transfer material has been filled in the inner space of the shield can 310, the heat transfer material may flow continuously without stopping and thus be discharged to the injection hole 314 and/or the opening 315 of the shield can 310. On the contrary, in case that a heat transfer material is formed with high viscosity, the heat transfer material may be difficult to be discharged from the nozzle. According to an embodiment of the disclosure, the composition of a heat transfer material may be configured to have a predetermined level of thermal conductive property and a viscosity which allows the heat transfer material to be easily discharged from a nozzle and a flow property of the heat transfer material to be easily controlled in the shield can 310.

In an embodiment, a heat transfer material may be formed such that a heat-dissipating particle has a filling amount of greater than or equal to 90% in a mixture constituting the heat transfer material. For example, the volume occupied by a heat-dissipating particle in a unit volume of a mixture constituting a heat transfer material may be 90% or more of the unit volume. If differently defined, the composition of a heat transfer material may include about 90 to 95 % by weight of a heat-dissipating particle. Therefore, as a heat-dissipating particle is composed of about 90 to 95 % by weight in a mixture constituting the heat transfer material, the heat transfer material may have a thermal conductivity of about 7 W/mK or more and 10 W/mk or less.

In an embodiment, a heat-dissipating particle may include various elements. In an embodiment, a heat-dissipating particle may be a ceramic-based particle such as Al2O3, AlN, SiC, Boron Nitride (BN), and Si3N4, an insulating-coated carbon-based particle (Carbon fibers, Graphene, or Graphite), and a combination thereof.

In an embodiment, a heat transfer material may be formed by mixing low-molecular silicone resin, polymer silicone resin, and silicone oil so as to have a predetermined level of viscosity. In an embodiment, polymer silicone resin may be connected to a nozzle so as to prevent heat-dissipating particles from being delaminated from other mixtures in a case in which a heat transfer material is stored. Low-molecular silicone resin and silicone oil may improve the property in which a heat transfer material is discharged from a nozzle.

In an embodiment, the composition of a heat transfer material may include about 1.3 to 4 % by weight of polymer silicone resin, about 0.5 to 1.5 % by weight of low-molecular silicone resin, and about 0 to 1.5 % by weight of silicone oil. The heat transfer material may have a viscosity of about 200,000 to 600,000 centipoise (CPS) according to the weight ratio of polymer silicone resin, low-molecular silicone resin, and silicone oil.

In an embodiment, silicone resin and silicone oil may have a [-Si(CH3)2O-]n structure such as polydimethylsiloxane (PDMS). The above-described polymer silicone resin and low-molecular silicone resin may be determined according to the molecular weight of silicone resin. For example, in case that the molecular weight of silicone resin is about 200 to 2000 molecular weight (Mw), the silicone resin may be low-molecular silicone resin. In addition, in case that the molecular weight of silicone resin is about 90,000 to 200,000 Mw, the silicone resin may be polymer silicone resin.

The composition of a heat transfer material of the disclosure may include about 90 to 95 % by weight of a heat-dissipating particle, about 1.3 to 4 % by weight of polymer silicone resin, about 0.5 to 1.5 % by weight of low-molecular silicone resin, and about 0 to 1.5 % by weight of silicone oil. Therefore, the heat transfer material may have a thermal conductivity of about 7 W/mk or more and 10 W/mk or less, and a viscosity of about 200,000 to 600,000 centipoise (CPS). As a result of examining a specific composition ratio of a heat-dissipating particle and a thermal conductivity and a viscosity based on same, when the composition of the heat transfer material is configured to include about 90 to 94 % by weight of a heat-dissipating particle, about 1.5 to 4 % by weight of high molecular silicone resin, about 0.5 to 1.5 % by weight of low molecular silicone resin, and about 0 to 1.5 % by weight of silicone oil, the heat transfer material may be configured to have a thermal conductivity of about 7 W/mk and a viscosity of about 200,000 to 400,000 CPS. In addition, when the composition of a heat transfer material is configured to include about 94 to 95 % by weight of a heat-dissipating particle, about 1.3 to 3 % by weight of high molecular silicone resin, about 0.5 to 1.3 % by weight of low molecular silicone resin, and about 0 to 1.2 % by weight of silicone oil, the heat transfer material may be configured to have a thermal conductivity of about 10W/mk and a viscosity of about 400,000 to 600,000 CPS.

The values of thermal conductivity and viscosity according to the composition of the heat transfer material described above may be examples, and the values of thermal conductivity and viscosity may be modified within a range which can be predicted by a person skilled in the art.

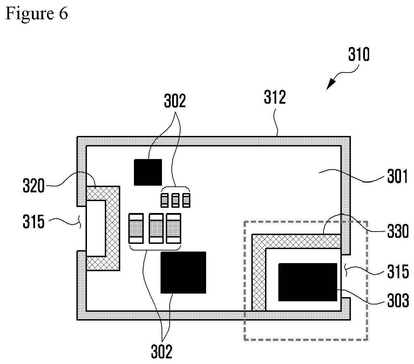

FIG. 6 is a view showing a second partition wall portion 330 of a shield can 310, which is disposed to surround a communication module 303 of a printed circuit board 301 according to an embodiment of the disclosure.

According to an embodiment, a communication module 303 may be disposed on the printed circuit board 301. In an embodiment, the communication module 303 may include a wireless communication module (e.g., the cellular communication module 303, a short-range wireless communication module, or a global navigation satellite system (GNSS) communication module) or a wired communication module (e.g., a local area network (LAN) communication module or a power line communication module). Among the communication modules, a corresponding communication module 303 may communicate with an external electronic device through a first network (e.g., a short-range communication network such as Bluetooth, wireless fidelity (Wi-Fi) direct, or infrared data association (IrDA)) or a second network (e.g., a long-range communication network such as a legacy cellular network, a 5G(fifth generation) network, a next-generation communication network, Internet, or a computer network (e.g., a LAN or WAN(wide area network))). The various types of communication modules 303 may be integrated into a single element (e.g., a single chip) or be implemented as separate multiple elements (e.g., multiple chips).

According to an embodiment, as illustrated in FIG. 6, the shield can 310 may include a second partition wall portion 330 surrounding the communication module 303 disposed on a printed circuit board 301. For example, the second partition wall portion 330 may be positioned between the printed circuit board 301 and the planar portion 311 of the shield can 310, and may have at least a portion surrounding the communication module 303 so that the communication module 303 is isolated from a space around the communication module inside the shield can 310.

In an embodiment, the second partition wall portion 330 may include a conductive material in order to shield electromagnetic waves generated in the electronic component 302 or disperse heat generated by the electronic component 302 to the surrounding area thereof. In an embodiment, the second partition wall portion 330 may block electrical noise generated by the communication module 303 from being induced to other electronic components 302 of the printed circuit board 301 as being disposed to surround the communication module 303. In addition, in an embodiment, the second partition wall portion 330 may block electrical noise generated by the electronic component 302 disposed on the printed circuit board 301 from being induced to the communication module 303.

In an embodiment, the communication module 303 may not come into contact with a heat transfer material injected through the injection hole 314 of the shield can 310 as being surrounded by the second partition wall portion 330. In an embodiment, the second partition wall portion 330 may block a heat transfer material from flowing into the opening 315 of the shield can 310, the opening being formed at a position adjacent to the communication module 303.

According to an embodiment, the second partition wall portion 330 may be formed separately from the shield can 310 and then be coupled to the shield can 310. For example, the second partition wall portion 330 may be coupled to the planar portion 311 of the shield can 310 by welding so as to be substantially perpendicular to the planar portion 311 of the shield can 310.

In an embodiment, the second partition wall portion 330 may be formed integrally with the shield can 310. For example, the second partition wall portion 330 may be formed to extend substantially perpendicularly to the planar portion 311 of the shield can 310 in the process of manufacturing the shield can 310.

In an embodiment, the second partition wall portion 330 may have no gap or have a micro-gap with respect to one surface of the printed circuit board 301 when disposed on the printed circuit board 301 in a state of being coupled to the shield can 310.

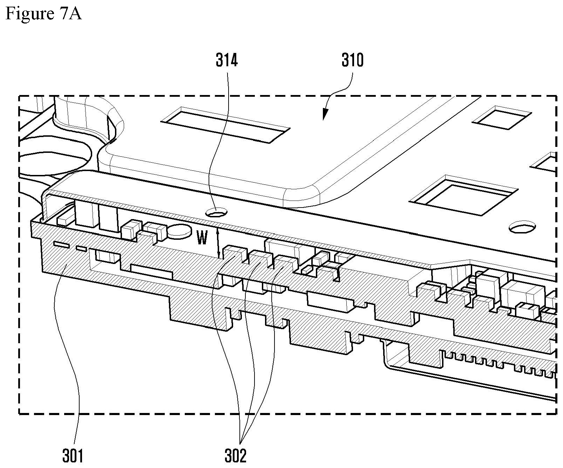

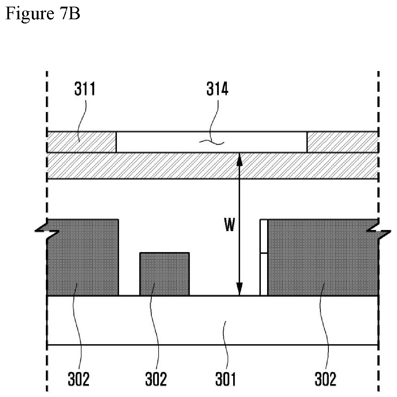

FIG. 7A and FIG. 7B are views showing a spaced distance between one surface of a printed circuit board and an injection hole, for preventing a heat transfer material filled in a shield can from flowing back into an injection hole according to an embodiment of the disclosure.

According to an embodiment, in case that a nozzle for spraying a heat transfer material faces the electronic component 302 on a printed circuit board 301 in a state of flowing into the injection hole 314 of a shield can 310 or a gap between the nozzle and the printed circuit board 301 is not sufficiently secured, the heat transfer material sprayed from the nozzle may flow back into the injection hole 314.

According to an embodiment of the disclosure, as shown in FIG. 7A and FIG. 7B, the shield can 310 may be formed to have a thickness which allows a predetermined interval W to be secured between the injection hole 314 and one surface of the printed circuit board 301. For example, when viewed in a direction substantially perpendicular to the planar portion 311 of the shield can 310, the injection hole 314 may have at least a portion which does not overlap the electronic component 302. In addition, the planar portion 311, through which the injection hole 314 is formed, of the shield can 310 may be spaced apart from the printed circuit board 301 while having a gap of 1 mm or more. Therefore, when a nozzle for spraying a heat transfer material is introduced into the injection hole 314 of the shield can 310, the gap between the printed circuit board 301 and the nozzle is sufficiently secured and accordingly, the phenomenon, in which a heat transfer material sprayed from the nozzle flows back through the injection hole 314, may be improved or prevented.

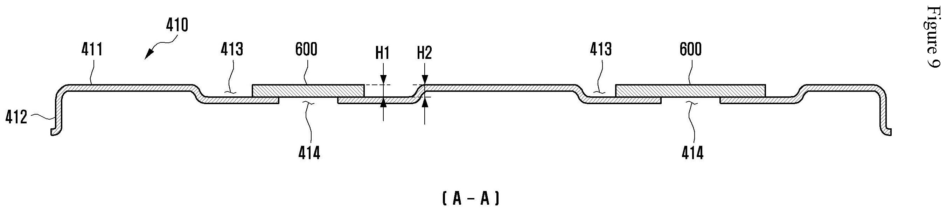

FIGS. 8A and 8B are views showing a seating portion, which has an injection hole formed therethrough and is formed in a groove shape, of a shield can, and a first cover member disposed in the seating portion according to an embodiment of the disclosure. FIG. 9 is a cross-sectional view taken along line A-A in FIG. 8B.

Hereinafter, a shield can 410 (e.g., the shield can 310 in FIG. 3A) having one surface concavely formed, the shield can 410 including a groove-shaped seating portion 413 in which the first cover member 600 is disposed, will be described. The following description of the shield can 410 may be the same as or similar to the description of the shield can 310 with reference to FIG. 3A to FIG. 7B. For example, the shield can 410 in FIGS. 8A and 8B and FIG. 9 may include a planar portion 411(e.g., the planar portion 311 in FIG. 3A), a side portion 412 (e.g., the side portion 312 in FIG. 3A), a seating portion 413(e.g., the seating portion 313 in FIG. 3A), an injection hole 414(e.g., an injection hole 314 in FIG. 3A), and an opening (not shown) (e.g., the opening 315 in FIG. 3A). Hereinafter, in connection with the same configuration as or the similar configuration to the shield can 310 in FIG. 3A to FIG. 7B, descriptions thereof will be omitted.

In addition, the structure of the shield can 410 described below may be identically applied to the shield can 310 described with reference to FIG. 3A to FIG. 7B.

According to an embodiment, FIG. 8A may be a view showing that a seating portion 413 having a groove shape is formed on a planar portion 411 of a shield can 410. FIG. 8B may be a view showing a state where an injection hole 414 formed through a seating portion 413 is covered by a first cover member 600 as the first cover member 600 is disposed in the seating portion 413 of the shield can 410.

According to an embodiment, as illustrated in FIG. 8A, the seating portion 413 may be formed in a groove shape in which one surface of the shield can 410 is concavely formed. For example, the seating portion 413 may be formed on one surface of the shield can 410 in a groove shape through press processing. In an embodiment, the injection hole 414 may be formed inside the seating portion 413. In an embodiment, referring to FIG. 8B, the first cover member 600 may be disposed in the seating portion 413 having a groove shape, and accordingly, may cover the injection hole 414. Therefore, a heat transfer material may not flow back to the outside of the shield can 410 through the injection hole 414.

According to an embodiment, as illustrated in FIGS. 8A and 8B, the first cover member 600 may include a cut part 601 formed by cutting a part of the first cover member 600. The cut part 601 may be formed to be bendable in the direction into which a nozzle is inserted as the nozzle for spraying a heat transfer material is inserted into the cut part 601. Accordingly, the cut part 601 may allow the nozzle to be inserted into the shield can 410 and may block the injection hole 414 formed through the seating portion 413 while the nozzle is not inserted therein.

According to an embodiment, as illustrated in FIG. 9, the seating portion 413 may be formed to have a size which allows the first cover member 600 to be accommodated therein. For example, a depth H2 of the seating portion 413 may be formed to be equal to the thickness H1 of the first cover member 600 or be greater than the thickness H1 of the first cover member 600. Therefore, the shield can 410 may not require an additional space in which the first cover member 600 is disposed, the additional space corresponding to as much as a space occupied by the first cover member 600 inside an electronic device (e.g., the electronic device 100 in FIG. 1A and FIG. 1B and/or the electronic device 200 in FIG. 2).

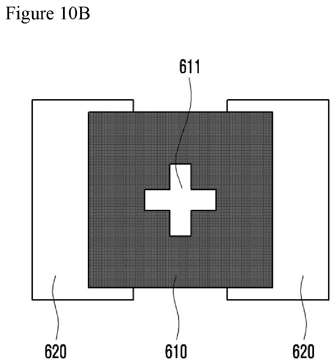

FIG. 10A is a view showing a second cover member disposed in a hole formed through a seating portion of a shield can according to an embodiment of the disclosure. FIG. 10B is a view showing a second cover member and a plate coupled to the second cover member according to an embodiment of the disclosure.

The shield can 510 below may be an embodiment of the shield can 510 in which the seating portion 413 of the shield can 410 in FIGS. 8A and 8B is formed in a hole shape corresponding to a cover member (e.g., the second cover member 610).

The following description of the shield can 510 may be the same as or similar to the description of the shield can 310 with reference to FIG. 3A to FIG. 7B. For example, the shield can 510 in FIGS. 8A and 8B and FIG. 9 may include a planar portion 511(e.g., the planar portion 311 in FIG. 3A), a side portion 512 (e.g., the side portion 312 in FIG. 3A), a seating portion 513(e.g., the seating portion 313 in FIG. 3A), an injection hole (not shown) (e.g., the injection hole 314 in FIG. 3A), and an opening (not shown) (e.g., the opening 315 in FIG. 3A). Hereinafter, in connection with the same configuration as or the similar configuration to the shield can 310 in FIG. 3A to FIG. 7B, descriptions thereof will be omitted. In addition, the structure of the shield can 510 described below may be identically applied to the shield can 310 described with reference to FIG. 3A to FIG. 7B.

According to an embodiment, as illustrated in FIG. 10A, the seating portion 513 may be a hole in which the second cover member 610 is disposed. For example, the seating portion 513 may be a hole having a shape corresponding to the second cover member 610 so as to allow the second cover member 610 to be disposed therein. In this case, an injection hole, into which a nozzle for spraying a heat transfer material is inserted, may be a part of the seating portion 513 or may be the cut part 611 formed by cutting a part of the second cover member 610. The cut part 611 may be formed to be bendable in a direction into which a nozzle is inserted as the nozzle is inserted into the cut part 611, so as to allow the nozzle to be inserted into the shield can 510 and prevent the backflow of the heat transfer material while the nozzle is not inserted therein.

In an embodiment, referring to FIG. 10A, the seating portion 513 may be formed to have a size capable of accommodating the second cover member 610. In an embodiment, a depth H4 of the seating portion 513 may be formed to be equal to the thickness H3 of the second cover member 610 or be greater than the thickness H3 of the second cover member 610. Therefore, the shield can 510 may not require an additional space in which the second cover member 610 is disposed, the additional space corresponding to as much as a space occupied by the second cover member 610 inside an electronic device (e.g., the electronic device 100 in FIG. 1A and FIG. 1B and/or the electronic device 200 in FIG. 2).

According to an embodiment, as illustrated in FIG. 10B, the second cover member 610 may be coupled to the shield can 510 by means of multiple plates 620. In an embodiment, the multiple plates 620 may be arranged to face each other with reference to the cut part 611 of the second cover member 610. In an embodiment, the multiple plates 620 may be formed of a metal material and thus may be soldered to the inner surface of the shield can 510. In addition, the multiple plates 620 may be coupled to the shield can 510 by means of adhesive tape or a coupling member (e.g., a bolt and a nut or a screw).

An electronic device 100 or 200 according to an embodiment of the disclosure may include a printed circuit board 240 or 301,

an electronic component 302 disposed on the printed circuit board, a shield can 310, 410, or 510 including a planar portion 311, 411, or 511 which includes a seating portion 313, 413, or 513 formed to have a groove shape including an injection hole and a side portion 312, 412, or 512 which extends from the planar portion, the shield can being coupled to the printed circuit board so as to cover the electronic component, a cover member 600 or 610 disposed in the seating portion of the shield can, and a heat transfer material filled inside the shield can. The cover member may be configured to be bendable for insertion of an external object for injecting the heat transfer material into the shield can through the injection hole.

In an embodiment, the cover member may include multiple cut parts 601 or 611 configured to be bendable in a direction into which the external object is inserted.

In an embodiment, the seating portion may be formed as a groove having a shape corresponding to the cover member, and the injection hole may be formed in the groove.

In an embodiment, at least a portion of the injection hole, when viewed in a direction substantially perpendicular to the planar portion of the shield can, may be configured so as not to overlap the electronic component.

In an embodiment, the groove of the seating portion may be formed to have a depth which allows the cover member to be accommodated in the groove.

In an embodiment, the groove of the seating portion may be formed as a hole having a shape corresponding to the cover member, and the hole may be formed to have a depth which allows the cover member to be accommodated therein.

In an embodiment, the electronic device may further include at least one plate 620 coupled to one surface of the cover member and coupled to the planar portion in the shield can.

In an embodiment, the shield can may include an opening 315 which is formed in the side portion of the shield can and faces a circuit of the printed circuit board, and a first partition wall portion 320 which is positioned between the printed circuit board and the planar portion of the shield can and at least a portion of which faces the opening to block the heat transfer material from flowing into the opening.

In an embodiment, the first partition wall portion may have at least a portion extending to the side portion so as to shield the opening.

In an embodiment, the electronic component may include a communication module 303. In an embodiment, the shield can may include a second partition wall portion 330 which is positioned between the printed circuit board and the planar portion of the shield can and at least a portion of which surrounds the communication module to isolate the communication module from a space around the communication module in the shield can.

In an embodiment, the heat transfer material may include polymer silicone resin of 1.3 to 4 % by weight, and low-molecule silicone resin of 0.5 to 1.5 % by weight.

In an embodiment, the heat transfer material may include silicone oil of 0.1 to 1.5 % by weight.

In an embodiment, the heat transfer material may have a viscosity of 20,0000 CPS to 600,000 CPS.

In an embodiment, the heat transfer material may include a heat-dissipating particle of 90 to 95 % by weight.

In an embodiment, the heat-dissipating particle may include at least one of Al2O3, AlN, SiC, Boron Nitride (BN), Si3N4, Carbon fibers, Graphene, or Graphite.

In an embodiment, the heat transfer material may have a thermal conductivity of 7 to 10 W/mK.

An electronic device 100 or 200 according to an embodiment of the disclosure may include a printed circuit board 240 or 301, an electronic component 302 disposed on the printed circuit board, a shield can 310, 410, or 510 including a planar portion 311, 411, or 511 which includes an injection hole and a side portion 312, 412, or 512 which extends from the planar portion and includes an opening 315, the shield can being coupled to the printed circuit board so as to cover the electronic component, a heat transfer material filled inside the shield can through the injection hole, and a first partition wall portion 320 which is positioned between the printed circuit board and the planar portion of the shield can in the shield can and at least a portion of which faces the opening to block the heat transfer material from flowing into the opening.

In an embodiment, the first partition wall portion may have at least a portion extending to the side portion in which the opening is formed, so as to shield the opening.

In an embodiment, the electronic device may further include a communication module 303 disposed on the printed circuit board, and a second partition wall portion 330 which is positioned between the printed circuit board and the planar portion of the shield can in the shield can and at least a portion of which surrounds the communication module to isolate the communication module from a space around the communication module in the shield can.

In an embodiment, a cover member 600 or 610, which is disposed in the shield can to shield the injection hole and includes multiple cut parts 601 or 611 bent in a direction into which an external object is inserted, may be included therein. The shield can may include a seating portion 313, 413, or 513 which has an injection hole formed therethrough and is formed to have a hole shape or a groove shape which allows the cover member to be disposed therein.

The disclosure may also include, in addition to the disclosed embodiments, an embodiment based on any combination of two or more of the disclosed embodiments and an embodiment including any combination of the features thereof. Even in case that the disclosure does not explicitly disclose that two features can be combined or two embodiments can be combined, it does not mean that the disclosure does not include the combinations, but it should be noted that the disclosure includes the combinations.

The technical subjects pursued in the disclosure may not be limited to the above-mentioned technical subjects, and other technical subjects which are not mentioned may be clearly understood from the following descriptions by those skilled in the art to which the disclosure pertains.

Advantageous effects obtainable from the disclosure may not be limited to the above-mentioned effects, and other effects which are not mentioned may be clearly understood, through the following descriptions, by those skilled in the art to which the disclosure pertains.

The electronic device according to an embodiment of the disclosure may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in an embodiment of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

An embodiment of the disclosure may be implemented as software (e.g., the program 101) including one or more instructions that are stored in a storage medium (e.g., the internal memory or external memory) that is readable by a machine (e.g., the electronic device). For example, a processor (e.g., the processor) of the machine (e.g., the electronic device 100) may invoke at least one of the one or more instructions stored in the storage medium, and execute it. This allows the machine to be operated to perform at least one function according to the at least one instruction invoked. The one or more instructions each may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may also be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device (100, 200) comprising:
a printed circuit board (240, 301);
an electronic component (302) disposed on the printed circuit board;
a shield can (310, 410, 510) comprising
a planar portion (311, 411, 511) having a seating portion (313, 413, 513) formed as a groove including an injection hole, and
a side portion (312, 412, 512) extending from the planar portion, the shield can being coupled to the printed circuit board to shield the electronic component;
a cover member (600, 610) disposed in the seating portion of the shield can; and
a heat transfer material filled inside the shield can,
wherein the cover member is bendable for insertion of an external object for injecting the heat transfer material inside the shield can through the injection hole.

2. The electronic device of claim 1, wherein the cover member comprises multiple cut parts (601, 611) configured to be bendable for insertion of the external object.

3. The electronic device of claim 1, wherein the seating portion is formed as the groove having a shape corresponding to the cover member, and
wherein the injection hole is formed in the groove.

4. The electronic device of claim 1, wherein the injection hole, when viewed from a direction perpendicular to the planar portion of the shield can, does not overlap with at least a portion of the electronic component.

5. The electronic device of claim 3, wherein the groove of the seating portion is formed to have a depth configured to accommodate the cover member.

6. The electronic device of claim 1, wherein the groove of the seating portion is formed as a hole in a shape corresponding to the cover member, and
wherein the hole is formed to have a depth that accommodates the cover member.

7. The electronic device of claim 6, further comprising one or more plates (620) coupled to the planar portion and the cover member in the inside of the shield can.

8. The electronic device of claim 1, wherein the shield can comprises:
an opening (315) which is formed in the side portion of the shield can and faces a circuit of the printed circuit board; and
a first partition wall portion (320) which is positioned between the printed circuit board and the planar portion of the shield can and comprises at least a portion facing the opening to block the heat transfer material from flowing into the opening.

9. The electronic device of claim 8, wherein the first partition wall portion extends at least partially to the side portion to shield the opening.

10. The electronic device of claim 1, wherein the electronic component includes a communication module (303), and
wherein the shield can comprises a second partition wall portion (330) located between the printed circuit board and the planar portion of the shield can, and at least partially enclosing the communication module to isolate the communication module from the surrounding space inside a shield can.

11. The electronic device of claim 1, wherein the heat transfer material includes polymer silicone resin of about 1.3 to 4 % by weight, and small molecule silicone resin of about 0.5 to 1.5 % by weight.

12. An electronic device (100, 200) comprising:
a printed circuit board (240, 301);
an electronic component (302) disposed on the printed circuit board;
a shield can (310, 410, 510) comprising a planar portion (311, 411, 511) comprising an injection hole, and a side portion (312, 412, 512) extending from the planar portion and comprising an opening (315), the shield can being coupled to the printed circuit board so as to cover the electronic component;
a heat transfer material filled inside the shield can through the injection hole; and
a first partition wall portion (320) which is positioned between the printed circuit board and the planar portion of the shield can in the shield can and at least a portion of which faces the opening to block the heat transfer material from flowing into the opening.

13. The electronic device of claim 12, wherein the first partition wall portion has at least a portion extending to the side portion in which the opening is formed, so as to shield the opening.

14. The electronic device of claim 12, further comprising:
a communication module (303) disposed on the printed circuit board; and
a second partition wall portion (330) which is positioned between the printed circuit board and the planar portion of the shield can in the shield can and at least a portion of which surrounds the communication module to isolate the communication module from a space around the communication module in the shield can.

15. The electronic device of claim 12, further comprising a cover member (600, 610) which is disposed in the shield can to shield the injection hole and comprises multiple cut parts (601, 611) bent in a direction into which an external object is inserted,
wherein the shield can comprises a seating portion (313, 413, 513) which has an injection hole formed therethrough and is formed to have a hole shape or a groove shape which allows the cover member to be disposed therein.
